Europäisches Patentamt

European Patent Office

Office européen des brevets

(11) Publication number: 0 384 571
A2

# EUROPEAN PATENT APPLICATION

(21) Application number: 90300606.2

(22) Date of filing: 22.01.90

(51) Int. Cl.5: G06F 15/72, G06F 15/60

(30) Priority: 20.02.89 JP 38226/89

(43) Date of publication of application:
29.08.90 Bulletin 90/35

(84) Designated Contracting States:
CH DE FR GB LI NL SE

(71) Applicant: HITACHI, LTD.
6, Kanda Surugadai 4-chome
Chiyoda-ku, Tokyo 100(JP)

(72) Inventor: Nakatsuaka, Noriko
3-17-1-502 Moriyama-cho
Hitachi-shi, Ibaraki 316(JP)
Inventor: Yokota, Takayoshi
3-17-2-304, Moriyama-cho
Hitachi-shi, Ibaraki 316(JP)
Inventor: Hamada, Nobuhiro
810 Isobe-cho, Hitachioota-shi
Ibaraki 313(JP)
Inventor: Eguchi, Kazuhiko
3-890-1 Mukouhara
Higashi Yamamoto-shi, Tokyo 189(JP)

(74) Representative: Calderbank, Thomas Roger et
al
MEWBURN ELLIS 2 Cursitor Street
London EC4A 1BQ(GB)

(54) A method of displaying a pattern automatically and a device for carrying out that method.

(57) Suppose that a plurality of elements e.g. logic devices are to be arranged in a pattern (array). Then, there are several predetermined relationships between those elements, e.g. interconnection relationships, functional relationships etc. First elements are input (11) and the elements are arranged according to one of one relationships (e.g. interconnection) by a basic arrangement processing part (14).

This produces an intermediate pattern. Then the intermediate pattern is investigated by an arrangement modification part (15) and the intermediate pattern is re-arranged according to one or more of the other arrangement relationships (e.g. function). The rules for this re-arrangement may be stored in an arrangement modification rule storing part (16) . The resultant pattern may then be displayed (12) e.g. by printing. In this way, it is possible to generate a pattern in which the relationship between the elements are clearly displayed. Means (154) may also be provided to enable a device according to the present invention to derive one or more further rules from a revised pattern input by a user.

## FIG. 1

# A METHOD OF DISPLAYING A PATTERN AUTOMATICALLY, AND A DEVICE FOR CARRYING OUT THAT METHOD

The present invention relates to a method of display, a pattern automatically, e.g by drawing. It is intended to be applied where that pattern is an arrangement of a plurality of elements, with there being at least one predetermined relationship defined between the elements. For example, the elements may be electronic components, and the relationship may relate to their relative location in a drawing in which they are interconnected. The present invention also relates to a device for displaying a pattern automatically, to a drawing produced by such a method or device, to the design of interconnection of electronic components using such a method or device, and the use of such a method or device in revising drawings which contain errors.

Traditionally, the arrangement of electronic components into a circuit or logic array has been carried out manually. The designer of the circuit or array first determines the necessary relationships between the components, and then makes attempts to draw the pattern of interconnection of those components so that the relationships are satisfied. This is a complex and skilled task, and takes a lot of time.

Known methods of automating pattern drawing are extremely limited. For example in Japanese patent application laid-open number 62-287372, it is known to pre-define one or more interconnected groups of circuit components, and then to analyse a drawing of those components, with their interconnections, to see whether any of those groups are present. If one or more of the groups is present, the group is replaced by a single block in the drawing. This simplifies the drawing, thereby making it easier to read, but gives no help in the production of the original drawing.

It is also known from Japanese patent laid-open number 61-34674 to define groups of components within a drawing, but again this disclosure gives no assistance in the production of an automated drawing.

Hence, there is no satisfactory prior art method for automating the drawing process. This causes the problem that drawing involves a significant amount of time. In particular there are three areas where the absence of an automated drawing method presents a problem.

Firstly, it has recently become known for semiconductor integrated circuits to be fabricated for a specific application, which application is defined by a user rather than the manufacturer of the integrated circuit. In some cases, the manufacturer of the integrated circuit will be supplied with a layout drawing of the integrated circuit, but often the manufacturer is supplied only with a list of components and their proposed interconnection. Therefore, the manufacturer must put a lot of time and effort into producing a drawing of the pattern of the components, and the cost of this makes a significant contribution to the total cost of the integrated circuit.

Secondly, it often occurs that a mistake is made in the logic or interconnection of electronic components, and to correct this it is normally simplest to revise the original list of components and their interconnection. Then, however, there is no graphical display of the new arrangement, and therefore the drawing process must be repeated.

Thirdly, it is envisaged that it will be possible for computer systems to analyse an algorithm or logical process, and to derive automatically a list of electronic components capable of satisfying that algorithm or process. However, there is currently no satisfactory method of presenting to the circuit designer a graphical representation of the components necessary for the algorithm or process, without investing a lot of time in the production of a drawing.

The present invention seeks to provide at least some automation of drawing. It proposes that one or more arrangement rules are defined corresponding to the relationship(s) between elements which are to be drawn in a pattern, the elements are automatically analysed to determine which are related by the relationship(s), and then the elements are arranged according to the rule(s).

In practice, there will normally be more than one rule, because there is normally more than one desired relationship between the elements. In this case the present invention proposes that a multi-stage method be carried out, in which the elements are first arranged according to one rule, and then re-arranged according to one or more further rules, that re-arrangement maintaining the relationship defined by the first rule.

For example, suppose the elements of the pattern are logic gates of a logic circuit. Each element will have one or more inputs and one or more outputs, but the most simple pattern arrangement involves the determination of which logic gate input is connected to which logic gate output, and to draw the pattern of logic gates so that their interconnections are correct. There are two ways of achieving this. Firstly, the processing could begin with a group of one or more logic gates at the output end of the array, and then investigate the inputs to those logic gates, to determine a second group of logic gates which input to the outputs of the first group. Then, the inputs to the second group of logic gates can be investigated to determine a third group of logic gates which input to the second group, and this process repeated through the logic circuit. Alternatively, the process may be reversed, in which case a group of logic gates at the input of the circuit may first be investigated, by noting their outputs and determining a second group of logic gates whose input corresponds to the output of the first, and this process repeated.

However, it is found that if this relatively simple patterning is applied to logic elements, the resulting drawing is difficult to understand. When human designers design a logic circuit, there is the tendency to group together similar types of elements. Therefore, it is preferable that there is a subsequent re-arrangement involving investigation of the function of the logic gates, with logic gates carrying out similar functions being grouped in a predetermined manner, e.g. linearly.

Of course, the present invention may involve alternative ways of grouping elements of a pattern. For example, the elements may be grouped by size or shape, or by relative orientation.

Furthermore, although the present invention defined above has particular application to the arrangement of electronic components or logic elements in a circuit, the present invention is not limited to this. For example, the present invention may relate to the design of an industrial plant, to the chronological ordering of events in a drawing list, or indeed to any other situation where it is necessary to produce a drawing of inter-related elements.

In the present invention as discussed above, at least some of the rules which determine the pattern to be imposed on the elements may be stored in a rule memory. The existance of such a rule memory leads to a further aspect of the present invention, namely the provision of a rule-learning system, which may be used in automated graphical analysis. Thus, suppose a pattern of elements has been prepared by an automated process, such as that defined above. Then, a designer makes a change to at least part of the pattern on the basis of his experience. Then, the present invention proposes that the revised pattern is analysed, to determine the rule which the designer has applied in making the revision, and then that new rule is stored in the rule memory. The rule may then be applied to other parts of the pattern, or to new patterns.

Embodiments of the present invention will now be described in detail, by way of example, with reference to the accompanying drawings, in which:

Fig. 1 shows a device for automatically drawing a pattern of elements, being a first embodiment of the present invention;

Fig. 2 is a flow chart showing the processing carried out by the embodiment of Fig. 1;

Figs. 3 to 5 show stages in the arrangement of elements for pattern, according to a method of the present invention;

Fig. 6 is another device for drawing a pattern automatically, being a second embodiment of the present invention;

Fig. 7 is a flow chart showing the functions carried out by the second embodiment of the present invention;

Fig. 8 is an example of a list of elements to be arranged in a pattern;

Fig. 9 is the result of a basic arrangement;

Fig. 10 is an example of a clustering rule used in the second embodiment of the present invention;

Fig. 11 is a flow diagram of the analysis of the list of Fig. 8;

Fig. 12 shows an example of a modification rule for a logic diagram arrangement;

Fig. 13 shows an example of the action of arrangement modification;

Fig. 14 shows an arrangement of components;

Fig. 15 shows stages in a method of drawing a logic diagram according to the present invention;

Fig. 16 illustrates an example of arrangement adjustment;

Fig. 17 shows a specific example of logic circuit elements arranged according to an interconnection rule;

Fig. 18 shows the pattern of logic elements of Fig. 17, re-arranged according to function;

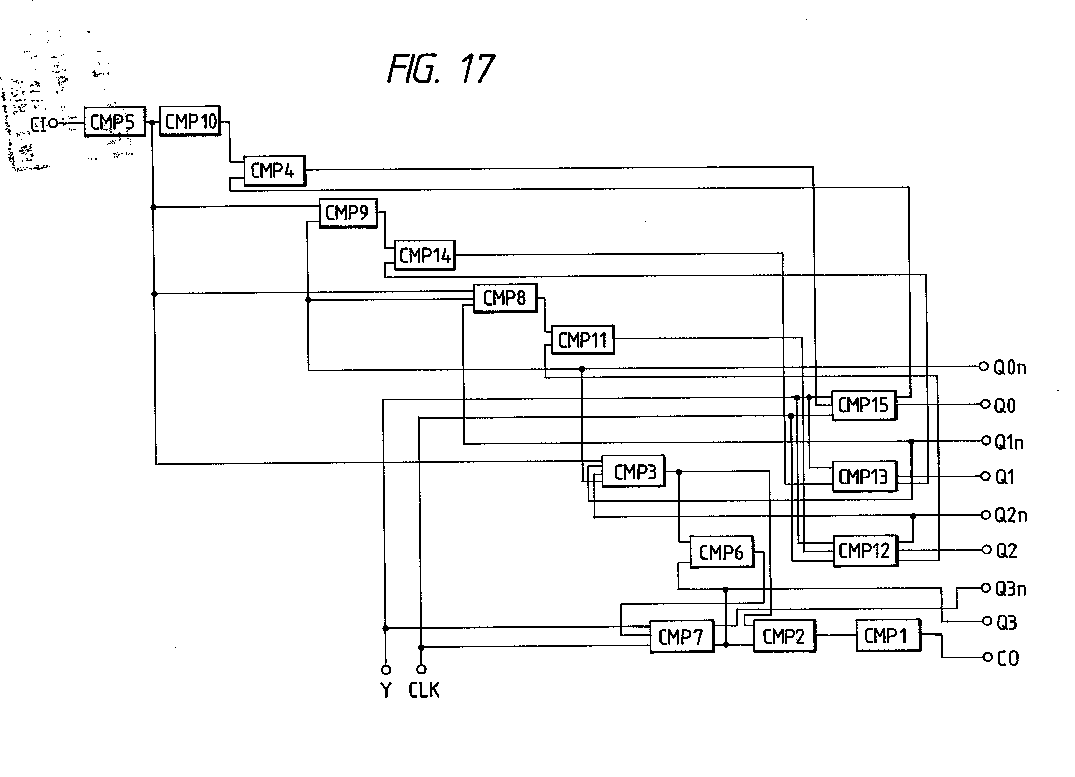

Fig. 17 shows another device for drawing automatically, being a third embodiment of the present invention;

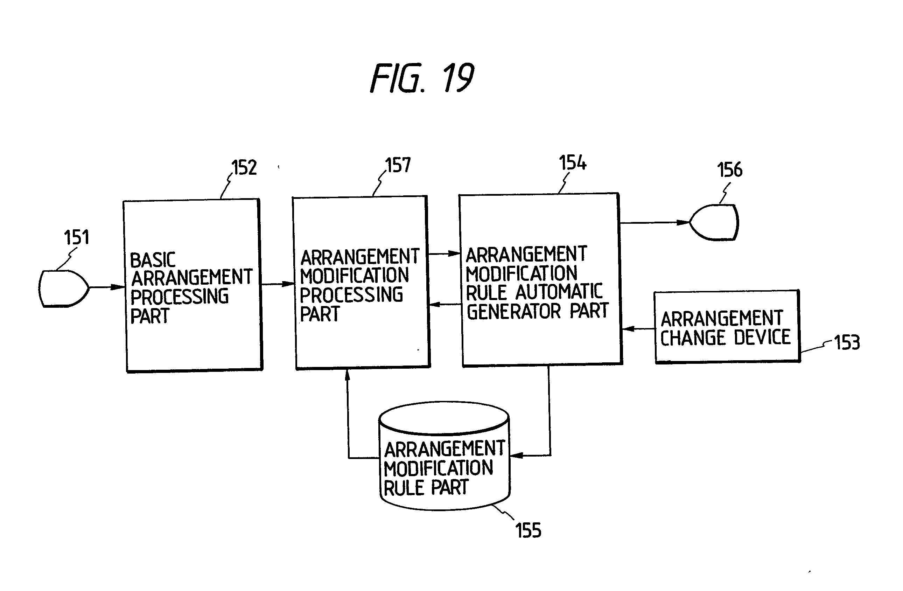

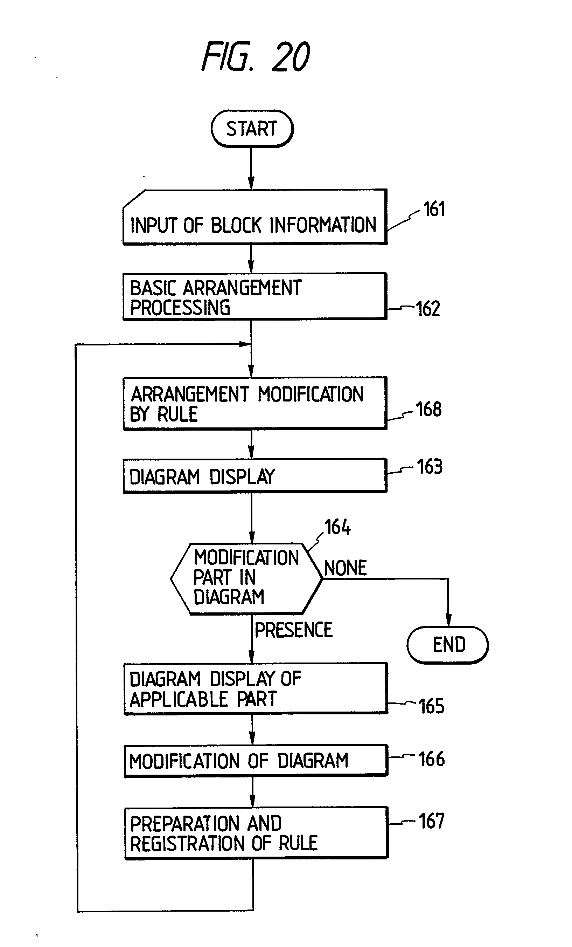

Fig. 20 is a flow diagram illustrating the functions of the device shown in Fig. 19;

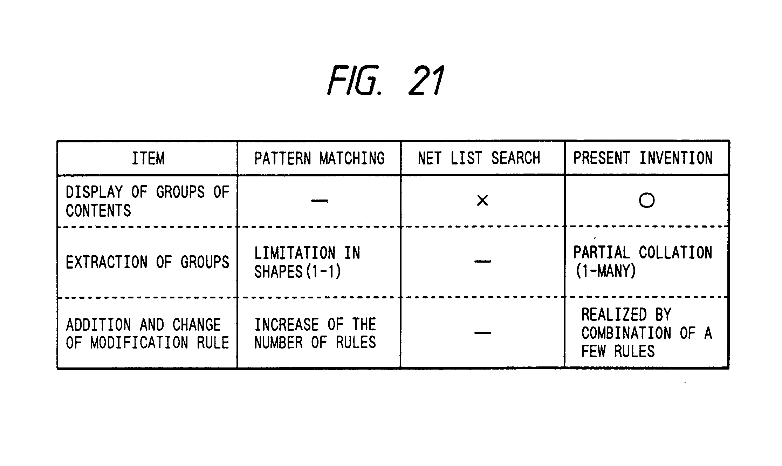

Fig. 21 is a table comparing the present invention with known methods;

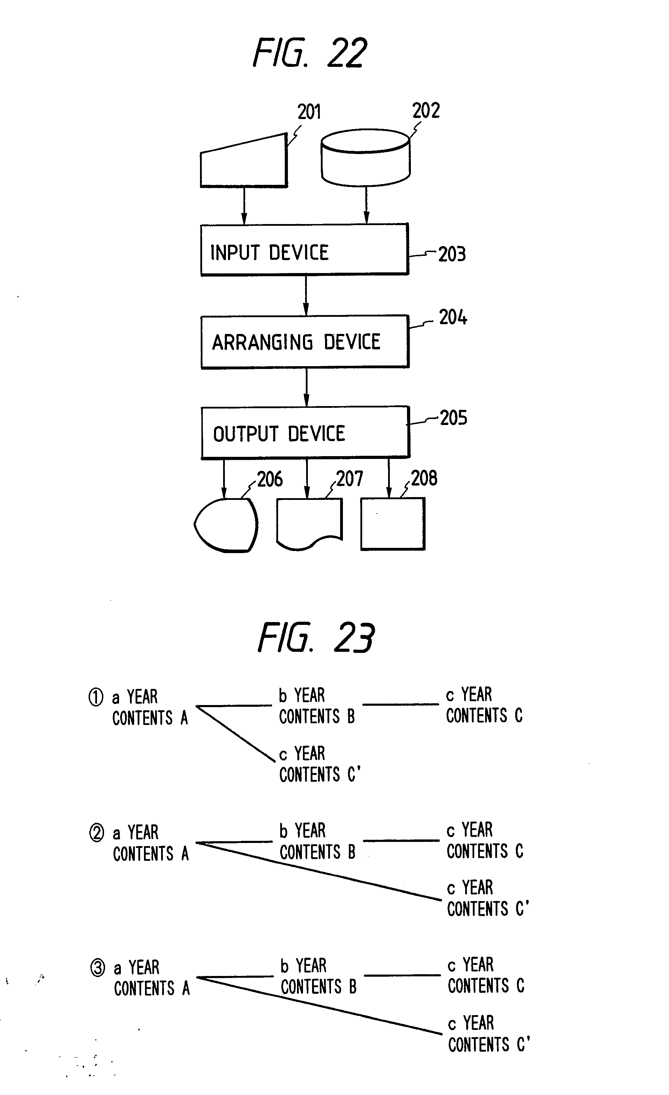

Fig. 22 illustrates a device being a fourth embodiment of the present invention, being for producing a chronological list drawing and

Fig. 23 shows a chronological list drawing produced by the fourth embodiment.

## Embodiment 1

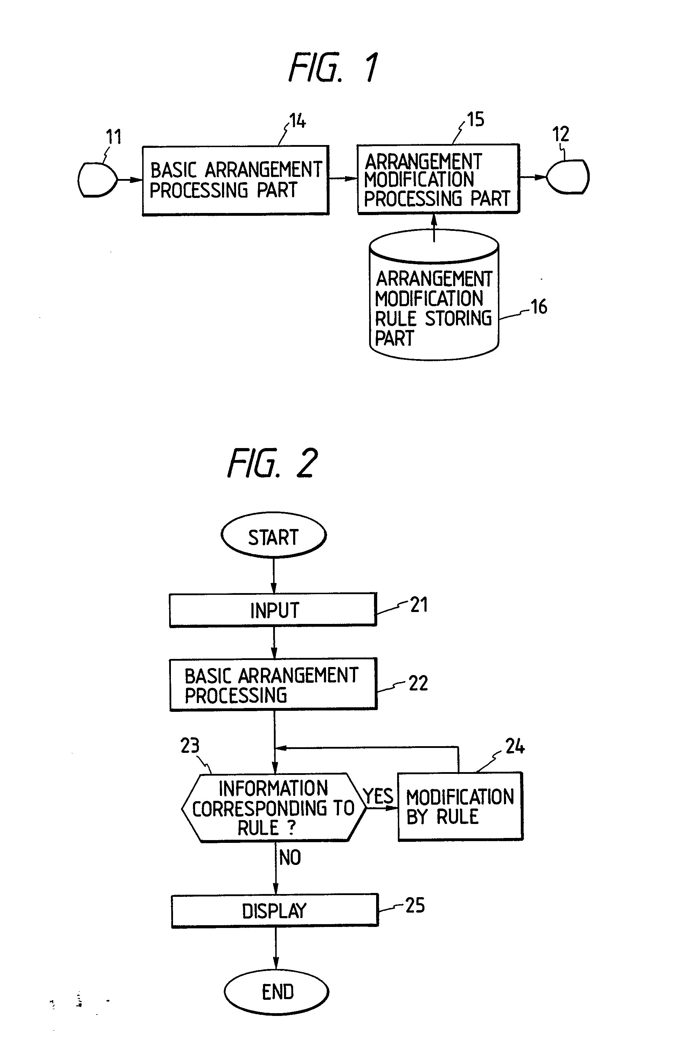

A first embodiment of the present invention will now be described, referring first to Fig. 1.

As illustrated in Fig. 1, the drawing device has an information input device 11, for receiving information concerning elements to be arranged in a pattern, such as the number of elements, their interconnection, their function, etc. A basic arrangement processing part 14 receiving the information concerning the elements and executing basic arrangement processing, an arrangement modification processing part 15 for identifying elements whose functions are related after the basic arrangement has been executed, and for carrying out modification processing as defined by a rule. The device also has an arrangement modification rule storing part (rule memory) 16 for storing the rules for arrangement modification, and a drawing output device 12 to present a final drawing.

The operation of the device shown in Fig. 1 will be discussed with reference to Fig. 2.

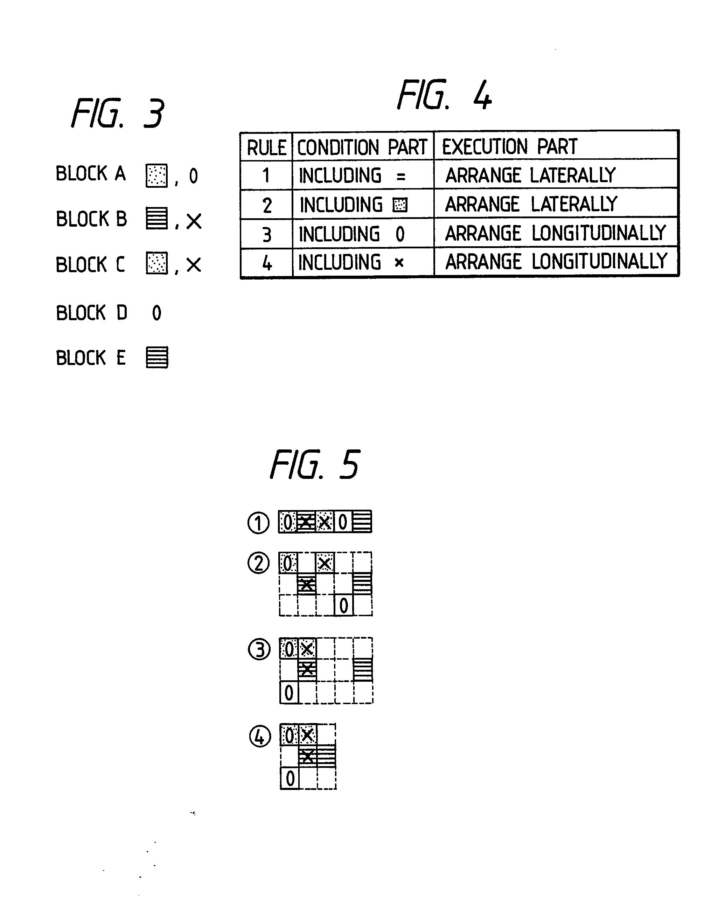

First, information about the elements at step 21 is read at the information input device 11. Keywords of the function of each block may be included in the element information, which information may then consist of the names of elements and keywords as shown in Fig. 3. In Fig. 3, the elements are represented by blocks and the keywords represented by circles, crosses and other patterns. The blocks are arranged by the basic arrangement processing part 14, (for example, they are arranged in order from the left (step 22 in Fig. 2) (22) according to the order of input based on the information which has been read. As a result, the arrangement result of Fig. 5 (1) is obtained for the input information shown in Fig. 3. Next, the arrangement modification processing part 15 refers in step 23 to the condition part of the rule stored in the arrangement modification rule storing part 16. An example of the rule stored in the arrangement modifications processing part is shown in Fig. 4. The condition part consists of keywords of the contents described as the block information. The arrangement modification processing part 15 collates the inputted block information with the keywords of each rule and extracts the blocks which include the keywords of the rule. Suppose that blocks having the same pattern are assumed to have the same keywords corresponding to the rule as shown in Fig. 4. The rule is executed for the blocks having the same keyword. In an example of the rule shown in Fig. 4 blocks having predetermined patterns ( ▨▨▨ ▦▦▦ ) of Fig. 5 (1) are arranged laterally as they have the same keyword. If the other blocks (e.g. block d, which does not include the patterns) ( ▨▨ ▦▦ ) exist on the same line as the blocks falling under the rule (the blocks a,b,c,e, which include ( ▨▨ ▦▦ ), their location is moved to the bottom line. The result of execution for blocks having those ground patterns is shown in Fig. 5(2). Next, if there is a rule that blocks having the keywords of a circle and a cross (the blocks a,b,c,d) are arranged longitudinally, the location of those blocks is moved to the furthest left row containing blocks with same keyword, as shown in Fig. 5(3). Then if there are rows with no blocks, those rows are filled by moving to the left blocks in other rows, as shown in Fig. 5(4) and the diagram is displayed by the output device 25. In this way, blocks can be arranged according to their content and group recognition of each block can be simplified.

## Embodiment 2

Next, a second embodiment of the present invention will be described, being a device for drawing a diagram of a logic circuit.

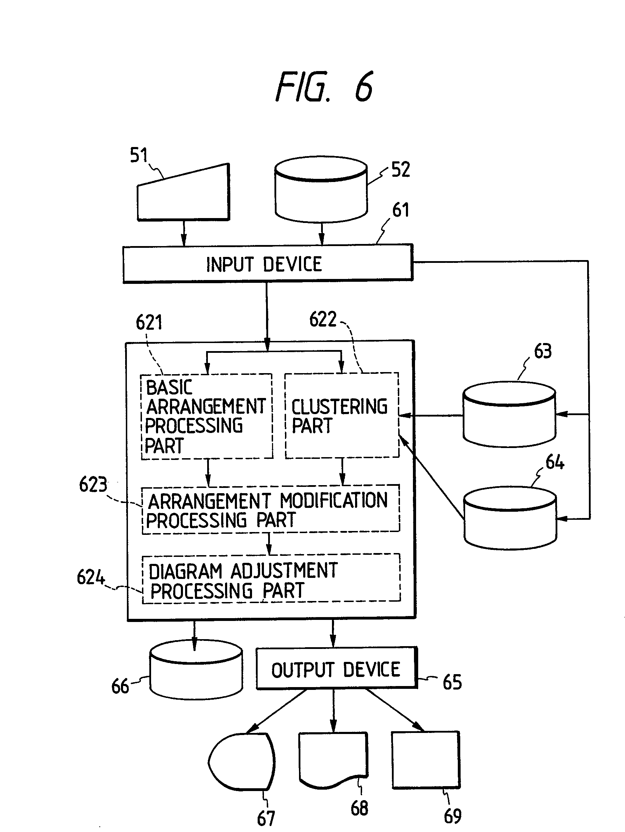

Fig. 6 shows a logic circuit drawing device which is provided with an input device 61 for receiving input information relating to logic elements and to the interconnection relationships and so forth from a keyboard 51 and an external memory device 52. The device 52 has a control device 62 for carrying out basic arrangement processing of the logic elements, executing modification processing on the diagram arrangement after analyzing the connection relationships between the logic elements and adjusting the diagram arrangement (i.e. re-arranging the pattern of the logic elements). External memory devices 63,64 store rules for arrangement modification and so forth. There is also an output device 65 for displaying the arrangement results as a diagram on e.g. a CRT (VDU) 67, a printer 68, or an XY plotter 69. An external memory device 66 may also store the arrangement results.

The control device 62 includes a basic arrangement processing part 621 for executing the basic arrangement processing of the logic elements, a clustering part 622 for analysing the net list which defines the interconnection relationships between the logic elements using rules stored in the external memory device 63, an arrangement modifying processing aprt 623 for carrying out partial modification of the arrangement and a diagram adjustment processing part 624 for adjusting the diagram for compaction of the arrangement and the wiring between the logic elements.

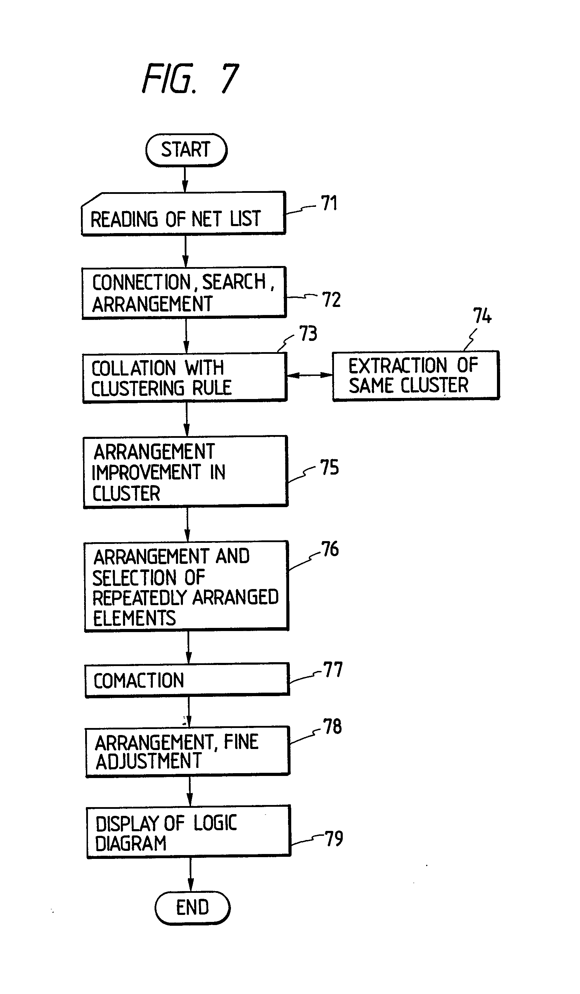

The steps in a method of drawing a logic diagram, using the device of Fig. 6 will now be explained referring to Fig. 7 and subsequent Figs.

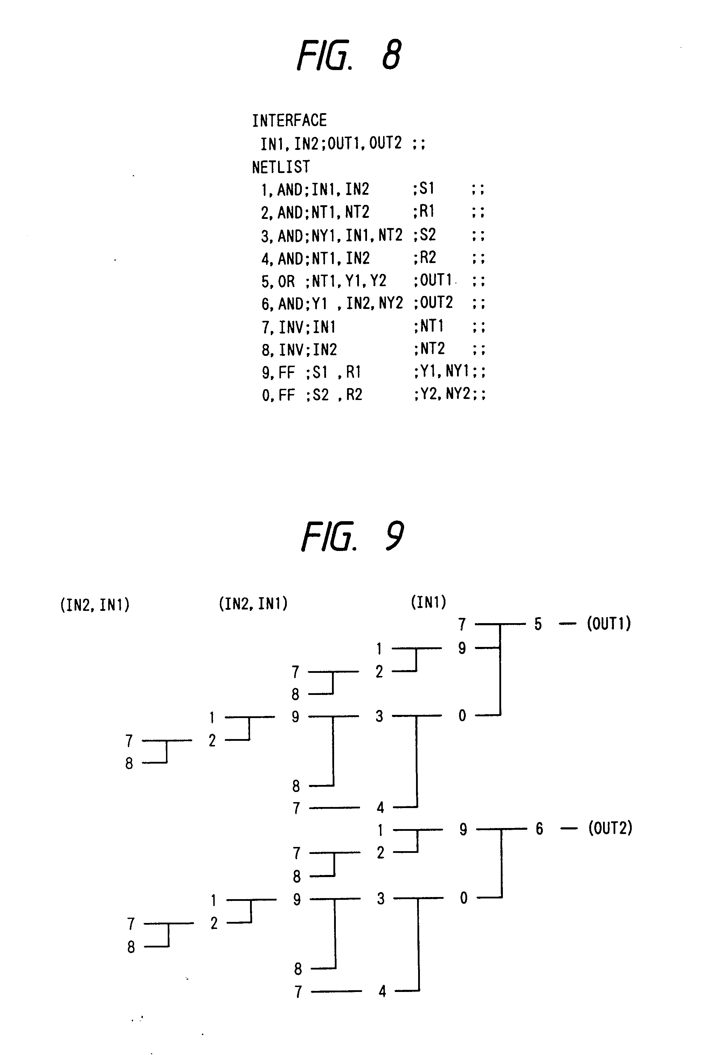

The input device 61, as an example reads a net list of logic elements predetermined in the form shown in Fig. 8 (a series of lines each containing the name of element; input(s) thereof; reading from the left from the external memory device 52 (step 71 in Fig. 7) and searches for the interconnection relationships. A first net structure is thus prepared. The basic arrangement processing part 621 of the control device 62 arranges the logic elements on a lattice in order from the output side as shown in Fig. 9 based on the net structure (step 72 in Fig 7). At this time, the direction of all the elements will be towards the right. This is basic arrangement processing.

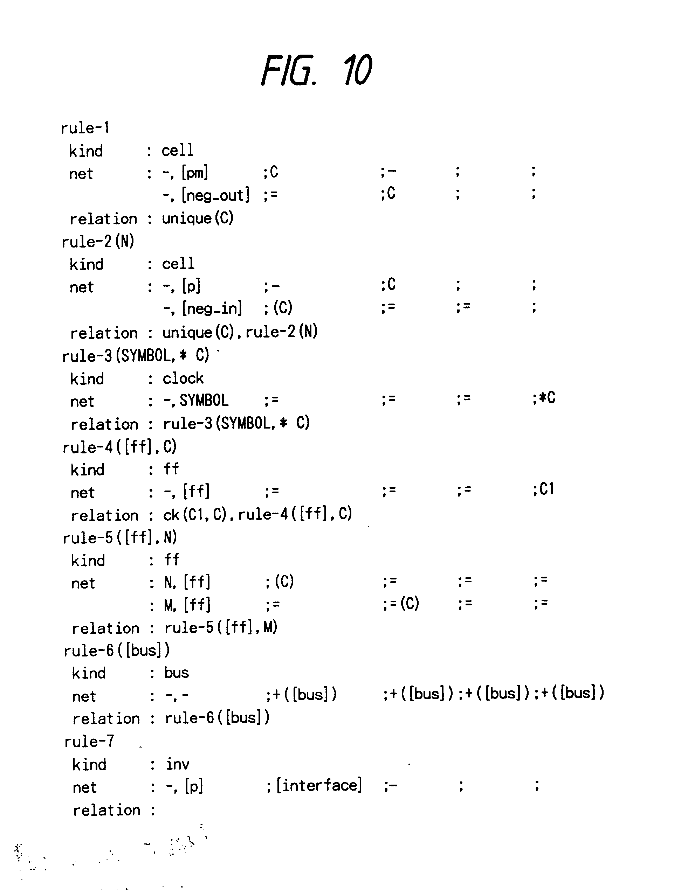

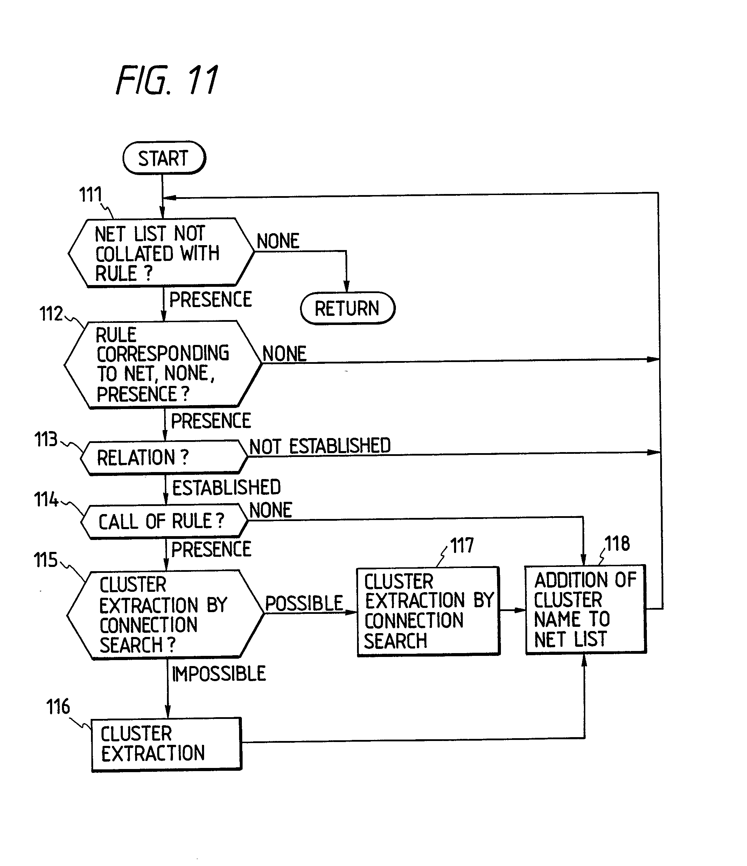

The clustering part 622 of the control device 62 extracts clusters of a few elements in a group which acheives a particular function (steps 73 and 74 in Fig. 7). As shown in Fig. 11, each of the net lists are collated with the net part of the rule stored in the element clustering rule shown in Fig. 10 which is stored in the external memory device 63 (steps 111 and 112 in Fig. 11), and it is checked whether or not the net list which accords with the net part of the rule satisfies each state except rule calls in the relation part (step 113 in Fig. 11). If the state is satisfied, the name of the cluster is added to the net list which has been collated with the rule (step 118 in Fig. 11). Further, if the rule call exists at the relation part, the rule is repeatedly implemented and those clusters satisfying the net part and the relation part are extracted, (if there are any). A cluster is extracted from the net list in the connection relations with the extracted cluster at this time (step 117 in Fig. 11), and if a cluster cannot be extracted from the net list in the connection relations, they are extracted from all net lists (step 116 in Fig. 11). A set of net lists which agree with the rule in the above method is arranged as a single cluster, and the name agreeing rules, and the arrangement zone in the search arrangement is registered (step 118 in Fig. 11). This operation is referred to as clustering.

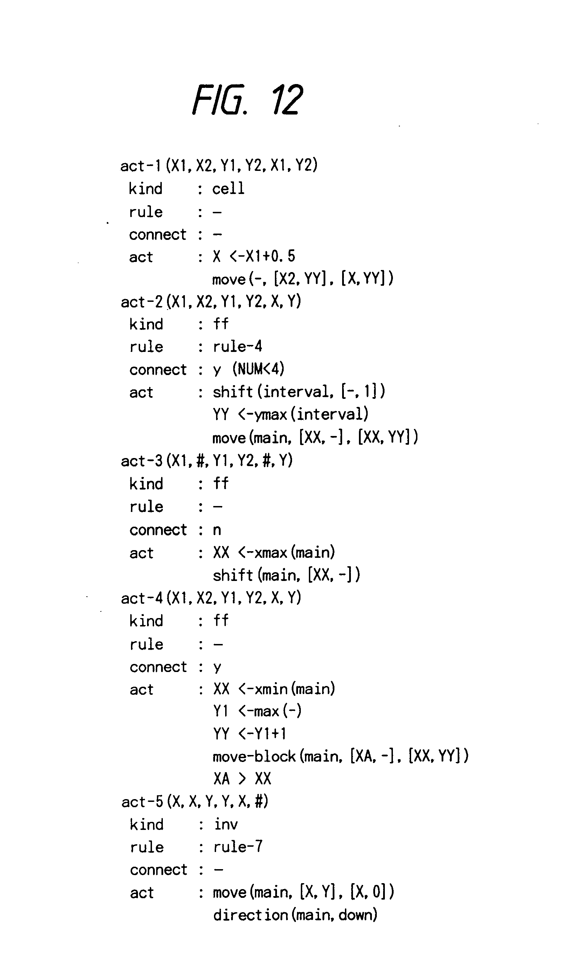

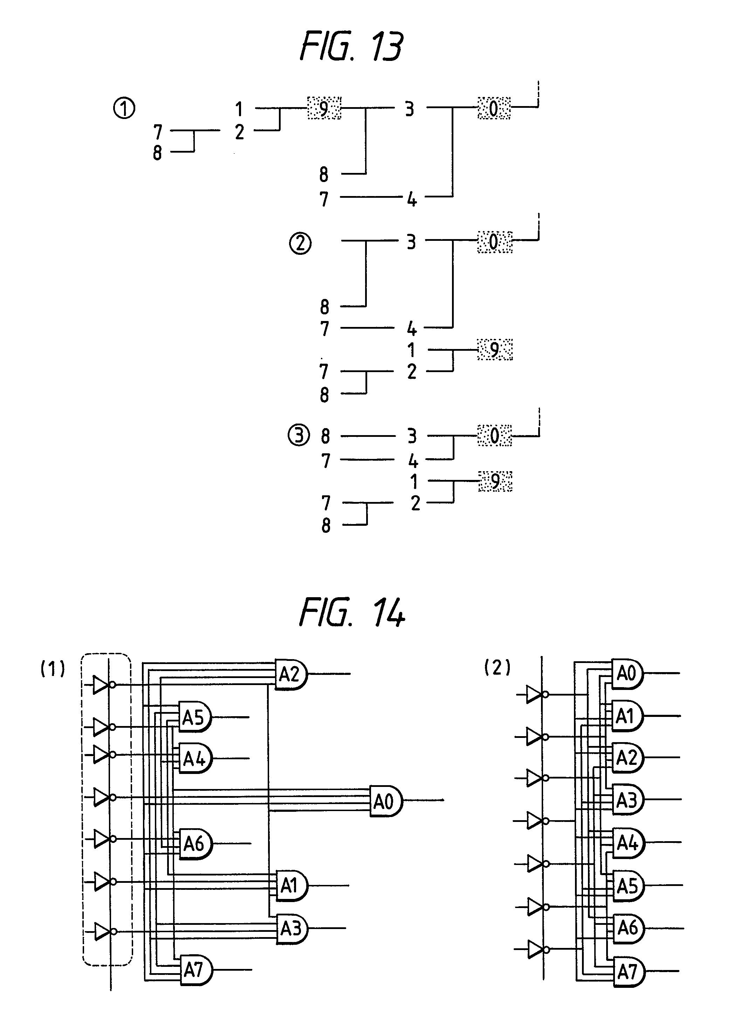

Next, the arrangement modification processing part 623 of the control device 62 modifies the arrangement according to the arrangement improvement rule shown in Fig. 12 stored in the external memory device 64. This arrangement operation is based on the name of the corresponding rule and the connection relationships of the logic elements concerning the zone of the elements of each cluster which has been clustered and registered and the elements between the prescribed clusters or in the neighbourhood of the cluster (step 75 in Fig. 7) . Thus, the connection relationships of the clusters and the type of collated elements are set in accordance with the condition part of the arrangement improvement rule. Also, the collated elements are arranged longitudinally or laterally and the logic elements between the collated elements are shifted in a desired direction as defined by the execution part of the arrangement improvement rule according to their condition. If necessary, processing to change the direction of some of the logic elements, in dependence on the adjacent logic elements is also included in this execution part. For example, suppose that the basic arrangement is as shown in Fig. 13 (1) and the elements 9 and 0 are flip-flops (FF) corresponding to rule-4 in Fig. 10 and act-4 in Fig. 12. In this case the flip-flops on the input side and the elements connected to the input side of the flip-flop are moved to the bottom line of the cluster as shown in Fig. 13(2) in order to arrange a line of flip-flops in order. The lines below those emptied by the movement shown in Fig. 13 (2) are shifted upward by the number of emptied lines. As a result, if it becomes larger than the element zone of the original cluster, the input side of the downward direction of the arrangement zone of the cluster is shifted by the increase amount and the diagram in the cluster after modification is inserted into the rest of the diagram. To determine the arrangement between the prescribed clusters, there is a decoder as shown in Fig. 14. The input of the decoder is transmitted after being synchronized by the suitable timing. Therefore, it is possible to reflect this on a diagram by arranging the number of arrangement steps in order with regard to the logic element connected to the output side of the cluster of the logic element connected to the output side of the cluster of the logic element which is synchronized and also to establish rules. Further if the names of signals of the decoder are described in the net list by (identical name + number), changing the arrangement of the numerical order of the signal names can also be defined by a rule.

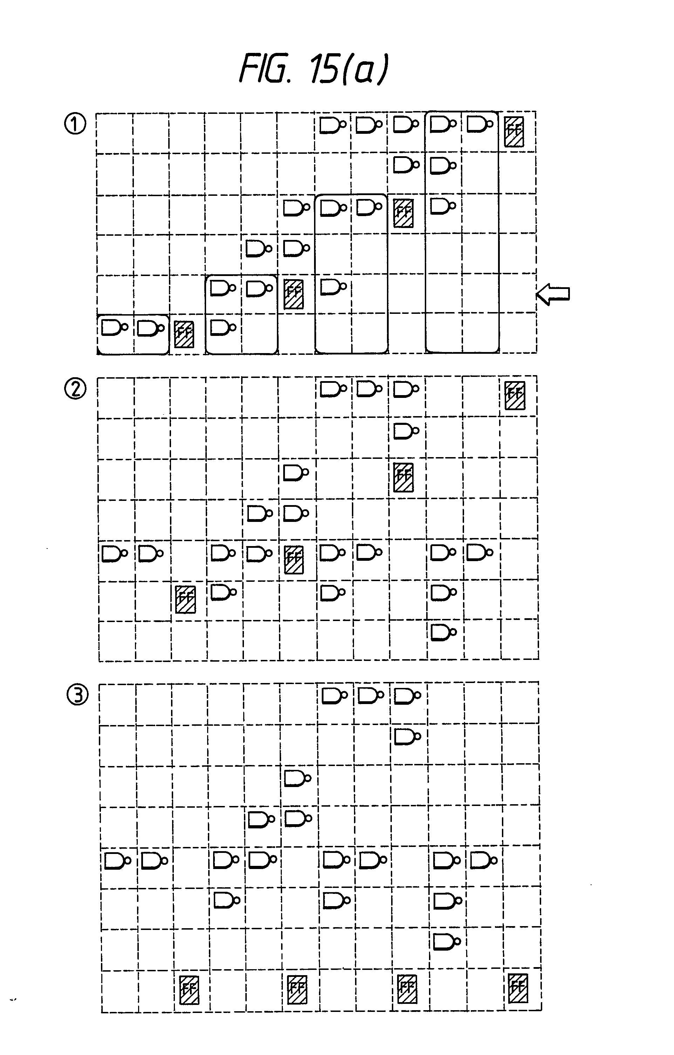

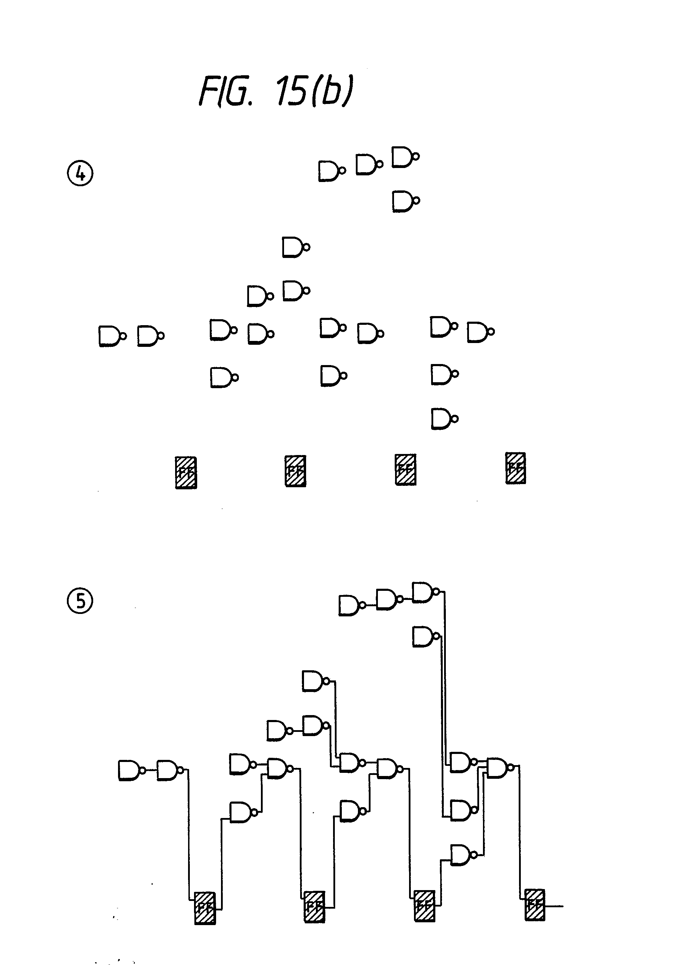

Figs. 15(a) and (b) illustrate the process to modify the arrangement of elements on the logic diagram. Fig. 15(a) (1) shows the result of a basic arrangement, and in this case rules to arrange flip-flops shown by slanted lines on a lateral line and a group of the elements connecting the flip-flop in a belt are defined. In Fig. 15(a) (2) the first step of the re-arrangment is shown in which a group of the elements connecting the flip-flop is shifted to a line below connecting the flip flops is shifted to a lower line (indicated by an arrow in Fig. 15(a) (1)) than the line of elements which do not fall under the flip-flop and a group of elements connecting the flip-flops. In shifting the group, the part of the arrangement containing no logic elements is reduced. In Fig. 15(a) (3), the flip-flops are shifted to a line below that of the elements shifted at the step shown in Fig. 15(a) (2). This new arrangement modification is achieved based on such a parallel movement (arrangement modification processing).

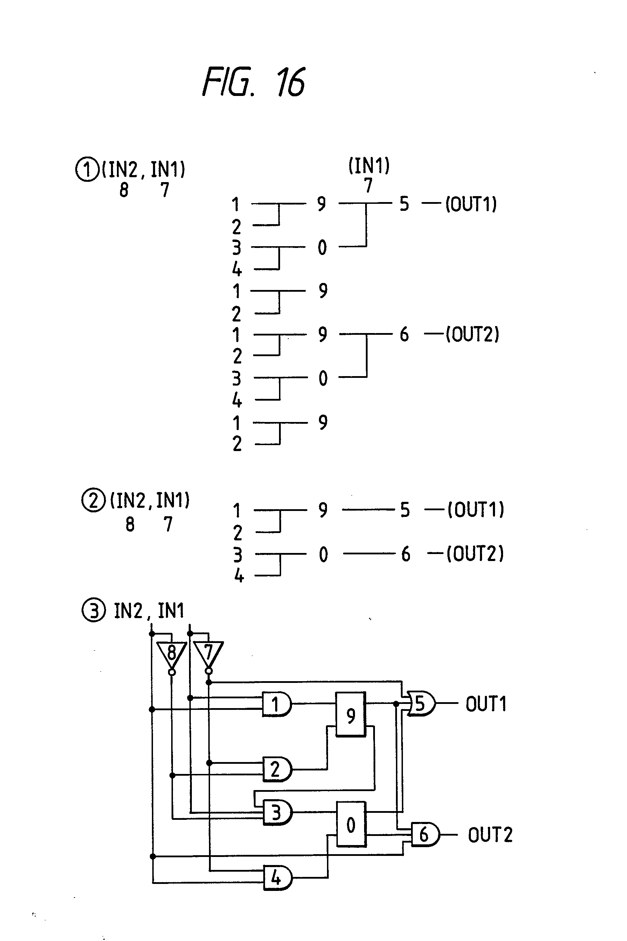

Next, the diagram adjustment processing 624 of the control device 62 as shown in Fig. 16, selects and arranges a line taking priority over the line next to the same cluster and a row taking priority over the row nearest the input side with regard to the same elements arranged together (step 76 in Fig. 7). Also, if there is a line or a row containing no logic element, the lines below it or rows on the input side of that empty row are shifted upward or to the ouput side (step 77 in Fig. 7). As shown in Fig. 15(b) (4), y coordinates of the terminal in the connection relations are arranged as for the elements adjoining each other (step 78 in Fig. 7). This is achieved by determining the arrangement in order, taking a prescribed arrangement interval line by line from the output side. Furthermore, as shown in Fig. 15(b) (5), pairs of elements whose arrangement has been determined are wired to each other based on the net structure (diagram adjustment processing).

Thus as discussed above, it is possible to display a part of a circuit having a group of functions which is easy to be seen can be obtained.

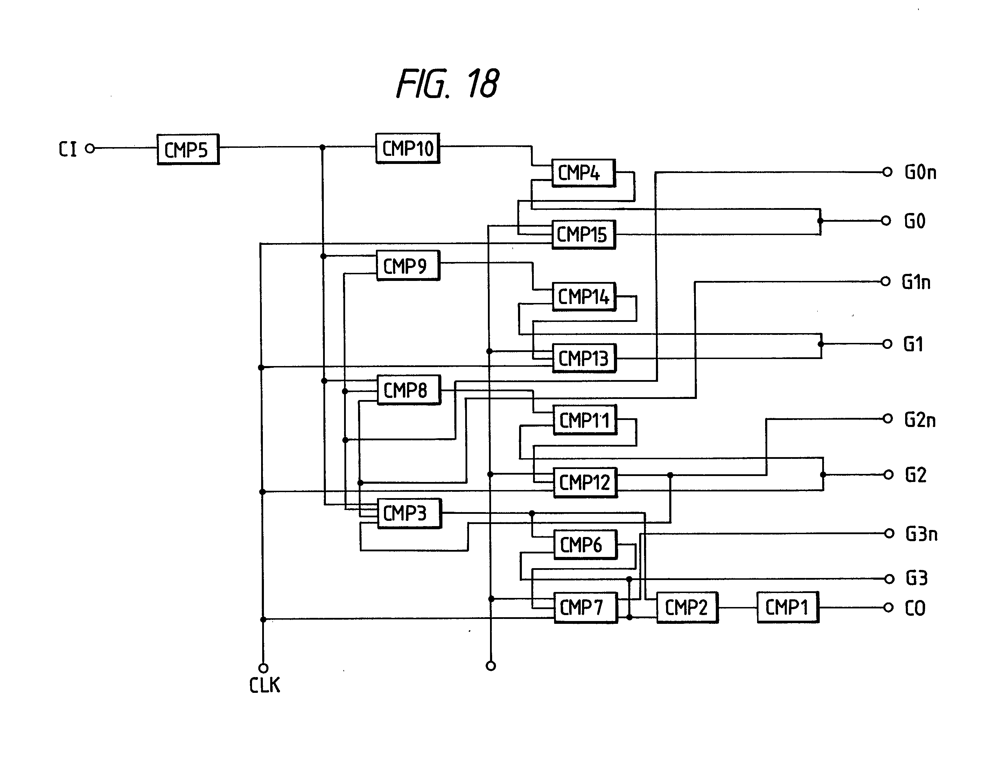

The practical result of the present invention can be seen in Figs. 17 and 18. As was mentioned above, the first step in the arrangement of a logic pattern is to determine the interconnection of the elements.

Preferably this is carried out starting from the output side, by investigating those logic elements at the output, and then investigating the inputs to those output logic elements. However, this operation may also be carried out starting at the input side. The result of this arrangement based on interconnection is shown in Fig. 17. The logic of the interconnection of the logic elements is now correct, but the drawing is difficult to understand without much analysis.

When a human circuit designer produces a drawing, there is a tendency to group together elements performing the same or a similar function. By establishing rules to define the inter-relationship of each element, by function, the arrangement shown in Fig. 17 may be rearranged to that shown in Fig. 18, which is more clear. In carrying out the re-arrangement, the interconnection established by the first arrangement are maintained, so that the logic of the interconnection of the logic elements remains correct.

Embodiment 3

A rule input device will now be described with reference to Fig. 19. That input device has a block information input device 151, a basic arrangement processing part 152, an arrangement change input part 153, an arrangement modification rule automatic generation part 154, an arrangement modification rule storing part 155, a diagram display 156 and a diagram modification processing part 157.

The operation of the device of Fig. 19 will now be described with reference to Fig. 20.

Firstly, the block information input device 151 reads information of the blocks 161 (being elements to be arranged in a pattern and the basic arrangement processing part 152 searches for the relationship for connecting the blocks and arranges the blocks in order from the left. If one block is to be connected to a plurality of others, the other ones in that connecting relationship are arranged longitudinally on its right side 162. If there is an existing arrangement modification rule, the arrangement is modified 168 according to the rule by the arrangement modification processing part 157. Next, the diagram display device 156 displays the arrangement result achieved by the processing 163 and inquires of the rule register if there is any part whose arrangement is to be modified 164. If there is a part to be modified, the rule register will input the diagram modification part and display it 165. The rule register directs the position to which the blcks are to be moved as to the block to be modified by the arrangement change device 153 based on the displayed diagram 166. When a stop message of modification on the diagram is sent by the rule register, the arrangement modification rule automatic generation part 154 extracts information included or not included in common in the blocks arranged longitudinally or laterally for which the rule register has modified their arrangement. Also the relative positions of the above longitudinally or laterally arranged blocks to the other blocks are determined. The arrangement modification rule automatic generation part 154 registers this result as an execution part and the above information as a condition part in the arrangement modification rule storing part 155 in a prescribed format.

The diagram modification processing part 158 modifies the whole screen according to the above rule 168 and displays 163 the modified diagram by the diagram display device 156. The above processing is repeated in the same manner till the rule register stops designating the diagram modification part, and a modification rule is prepared and registered while modifying the diagram.

This makes it possible for a rule registrar to prepare the register rules by this device based on the modified diagram with watching the diagram, and rules can be added easily.

Thus, with this embodiment, it is possible to provide a "rule learning" function. Suppose that a pattern of elements has been generated using rules stored in the arrangement modification rule part 155. Then, suppose a skilled designer (rule register) of such patterns of elements modifies part or all the pattern, applying a rule known from experience but not stored in the arrangement modification rule part. Then, the device may process that modified pattern and the arrangement modification rule automatic generation part 154 may determine the rule that the designer has used. That rule can then be stored on the arrangement modification rule part, for use in modifying the rest of the pattern, or as the arrangement of further elements to be arranged in a further pattern.

A comparative list with other systems is shown in Fig. 21. For other systems, there are an arrangement device by pattern matching and a net search arrangement corresponding only to the basic arrangement processing explained above, while the present invention may provide the advantages of both.

Embodiment 4

As shown in Fig. 20, a chronological list drawing device consists of an input device 201, an arranging device 202 and an output device 203.

In a sequence net, years and events are inputted by a keyboard 201 and an external memory device 202, and the input device 203 reads the input data. As shown in Fig. 21(1), the sequence net is searched and an initial arrangement is made from the read input data at the arranging device 204. Further the arranging device 204 extracts the contents in the same year. In Fig. 21, a plurality of c years exist, but if their exist contents having the same year, X coordinates on which the above contents are arranged compared, the difference from the largest X coordinate is determined and those contents connected to the above are shifted by the above difference as shown in Fig. 21(2). The output device 205 displays years on the top line and only the contents in the lower side as a net on a display 206, a printer 207 or a plotter 208 as shown in Fig. 21 (3). Preparation of a chronological net, a semantic net and so forth which shows the progress of events becomes easy by use of the present invention.

As mentioned above, by preparing various diagrams not limited to a logic diagram whose basic elements can be described in block, the diagrams which can easily be understood and analysed by the user are displayed and outputted.

The present invention provides a device which automatically arranges elements in a pattern. Therefore, it becomes possible to detemine from the drawing the relationships between the elements and the characteristics of the elements.

## Claims

1. A method of displaying a pattern automatically, said pattern being an arrangement of a plurality of elements, there being at least one predetermined relationship defined between said elements, and at least one pre-defined arrangement rule corresponding to said at least one predetermined relationship; the method comprising:
analysing said elements to determine which of said elements are related by said at least one predetermined relationship;
arranging said elements according to the at least one arrangement rule corresponding to said at least one relationship thereby to derive said pattern; and
displaying said pattern.

2. A method according to claim 1, wherein said at least one predetermined relationship is a first predetermined relationship, said at least one pre-defined arrangement rule is a first pre-defined arrangement rule, there is a second predetermined relationship defined between said elements, there is a second pre-defined arrangement rule corresponding to the second predetermined relationship, and the pattern defined by said arrangement step is an intermediate pattern, said method further including, prior to the display of the pattern;
analysing said intermediate pattern to determine which of said elements are related by said second relationship; and
rearranging at least some of said elements according to said second arrangement rule, thereby to derive said pattern, said re-arrangement being such that said first rule is maintained for said elements.

3. A method according to claim 1 or claim 2, wherein said at least one relationship or said first predetermined relationship relates to the interconnection of said elements.

4. A method according to claim 3, wherein said elements are circuit elements each having at least one input and at least one output and said at least one predetermined relationship or said first predetermined relationship relates to the connection of said at least one output of some of said elements to said at least one input of others of said elements.

5. A method according to claim 3, wherein said elements are circuit elements each having at least one input and at least one output and said at least one predetermined relationship or said first predetermined relationship relates to the connection of said at least one output of some of said elements to said at least one input of others of said elements.

6. A method according to claim 1, wherein said at least one predetermined relationship relates to the function of said elements.

7. A method according to claim 2, or any one of claims 3 to 5 as dependent on claim 2, wherein said second predetermined relationship relates to the function of said elements.

8. A method according to claim 1, wherein said at least one predetermined relationship relates to the size of said elements.

9. A method according to claim 2, or any one of claims 3 to 5 as dependent on claim 2, wherein said second predetermined relationship relates to the size of said elements.

10. A method according to claim 1, wherein said at least one predetermined relationship relates to the shape of said elements.

11. A method according to claim 2, or any one of claims 3 to 5 as dependent on claim 2, wherein said second predetermined relationship relates to the shape of said elements.

12. A method according to any one of the preceding claims, wherein said step of rearranging at least some of said elements comprises arranging said at least some of said elements in at least one group having a linear relative position.

13. A method according to any one of the preceding claims, wherein there are further pre-defined relationships defined between said elements, and further pre-defined arrangement rules correspond to said further pre-defined relationships, and said step of re-arranging at least some of said elements involves application to said elements of at least some of said further rules.

14. A method according to claim 13 as dependent on claim 2, further including the steps of storing said second rule and said further rules in a rule memory, and selecting said second rule and at least some of said further rules in dependence on said elements priorito said rearranging step.

15. A method according to any one of the preceding claims, further comprising the steps of analysing a further pattern of elements, said further pattern differing from said pattern by a change in the arrangement of at least some of said elements; and deriving a further rule defining the change in arrangement of said at least some of said elements.

16. A method according to any one of the preceding claims wherein there is a change in only some of said elements and the method further includes the steps of re-arranging at least some other elements of said plurality of elements according to said further rule to derive a further pattern, and re-drawing said further pattern.

17. A method according to claim 15 further including:
storing said further rule; and
subsequently re-arranging at least some elements of a further pattern of elements according to at least said further rules.

18. A device for displaying a pattern automatically said pattern being an arrangement of a plurality of elements, there being at least one predetermined relationship defined between said elements, and at least one pre-defined arrangement rule corresponding to said at least one predetermined relationship; said device comprising:
means for analysing said elements to determine which of said elements are related by said at least one predetermined relationship;
means for arranging said elements according to said at least one arrangement rule corresponding to said at least one relationship and for deriving said pattern; and
means for displaying said pattern.

19. A device for displaying a pattern automatically, said pattern being an arrangment of a plurality of elements, there being at least a first and a second predetermined relationship defined between said elements and a first and a second pre-defined arrangement rule corresponding to said first and second predetermined relationships, respectively;
said device comprising:
means for analysing said elements to determine which of said elements are related by said first relationship;
means for arranging said elements according to said first rule, and for deriving an intermediate pattern;
means for analysing said intermediate pattern to determined which of said elements are related by said second relationship;
means for re-arranging at least some of said elements according to said second rule, and for deriving said pattern, such that said first rule is maintained for said element; and
means for displaying said pattern.

20. A device according to claim 19, having a rule memory for storing said first and second rules.

21. A method of automatic graphical analysis, comprising:
analysing a first pattern of elements;
analysing a second pattern of said elements, said second pattern differing from said first pattern by a change in arrangement of at least some of said elements; and
deriving a rule defining the change in arrangement of said at least some of said elements.

22. A method according to claim 21, wherein there is a change in only some of said elements and the method further includes re-arranging at least some other elements of said plurality of elements according to said rule.

23. A method according to claim 21 further including:
storing said rule; and
subsequently re-arranging at least some elements of a third pattern of elements according to said rule.

24. A drawing produced by an automated display device according to any one of claims 18 to 20.

25. A method of designing an array of interconnected electronic components, said array being an arrangement of said electronic components, comprising drawing the array by a method according to any one of claims 1 to 17, with said pre-defined arrangement rule(s) including at least one interconnection arrangement rule so that representations of said electronic components are drawn in an array, with said representations of said electronic components being interconnected according to said at least one interconnection arrangement rule.

26. A method of investigating a list of related elements, wherein a pattern of the components of the list are drawn by a method according to any one of claims 1 to 17, and said drawn pattern is investigated.

27. A method of revising a list of elements comprising:
investigating the list by the method of claim 26, to detect errors in the pattern;
revising the list to generate a new list; and repeating the investigation until no errors are detected, thereby to obtain a correct list.

28. A method of correcting errors in a drawing prepared from a list of related elements, comprising:
investigating the list by the method of claim 26 to detect errors in the pattern;
revising the drawing to remove said error and generate a revised drawing;
automatically deriving a new list of said elements from said revised drawing; and
repeating the investigation of the new list, until no errors are detected in the array.

# FIG. 1

```
  11          14                           15              12
  ⬡  ──▶  ┌──────────────────┐   ┌──────────────────┐  ──▶  ⬡
          │ BASIC ARRANGEMENT │──▶│ ARRANGEMENT      │
          │ PROCESSING PART   │   │ MODIFICATION     │
          └──────────────────┘   │ PROCESSING PART  │
                                 └──────────────────┘
                                          ▲
                                 ┌──────────────────┐
                                 │ ARRANGEMENT      │
                                 │ MODIFICATION     │    16
                                 │ RULE  STORING    │
                                 │ PART             │
                                 └──────────────────┘
```

# FIG. 2

```
              ┌───────────┐
              │   START   │
              └───────────┘
                    │
                    ▼
        ┌───────────────────────┐
        │        INPUT          │── 21
        └───────────────────────┘
                    │
                    ▼
        ┌───────────────────────┐
        │  BASIC ARRANGEMENT    │── 22
        │  PROCESSING           │
        └───────────────────────┘
                    │
     23             ▼                          24
        ╱───────────────────╲   YES  ┌──────────────┐
       ╱   INFORMATION        ╲─────▶│ MODIFICATION │
       ╲ CORRESPONDING TO     ╱      │   BY RULE    │
        ╲     RULE ?         ╱       └──────────────┘
         ╲─────────────────╱
                    │ NO
                    ▼
        ┌───────────────────────┐
        │       DISPLAY         │── 25
        └───────────────────────┘
                    │
                    ▼
              ┌───────────┐
              │    END    │
              └───────────┘
```

# FIG. 3

BLOCK A  ▨ , 0

BLOCK B  ▤ , ✕

BLOCK C  ▨ , ✕

BLOCK D  0

BLOCK E  ▤

# FIG. 4

| RULE | CONDITION PART | EXECUTION PART |
|------|----------------|----------------|
| 1 | INCLUDING = | ARRANGE LATERALLY |
| 2 | INCLUDING ▨ | ARRANGE LATERALLY |
| 3 | INCLUDING 0 | ARRANGE LONGITUDINALLY |
| 4 | INCLUDING ✕ | ARRANGE LONGITUDINALLY |

# FIG. 5

① | 0 | ✕ | ✕ | 0 | ▤ |

② 

③ 

④

# FIG. 6

## FIG. 7

```
        ( START )
            │
            ▼
┌─────────────────────┐
│ READING OF NET LIST │ ──── 71
└─────────────────────┘
            │
            ▼
┌─────────────────────┐
│ CONNECTION, SEARCH, │ ──── 72
│ ARRANGEMENT         │
└─────────────────────┘
            │
            ▼
┌─────────────────────┐ 73        74
│ COLLATION WITH      │◄──►┌─────────────────┐
│ CLUSTERING RULE     │    │ EXTRACTION OF   │
└─────────────────────┘    │ SAME CLUSTER    │
            │              └─────────────────┘
            ▼
┌─────────────────────┐
│ ARRANGEMENT         │
│ IMPROVEMENT IN      │ ──── 75
│ CLUSTER             │
└─────────────────────┘
            │
            ▼
┌─────────────────────┐
│ ARRANGEMENT AND     │ ──── 76
│ SELECTION OF        │
│ REPEATEDLY ARRANGED │
│ ELEMENTS            │
└─────────────────────┘
            │
            ▼
┌─────────────────────┐
│ COMACTION           │ ──── 77
└─────────────────────┘
            │
            ▼
┌─────────────────────┐
│ ARRANGEMENT, FINE   │ ──── 78
│ ADJUSTMENT          │
└─────────────────────┘
            │
            ▼
┌─────────────────────┐
│ DISPLAY OF LOGIC    │ ──── 79
│ DIAGRAM             │
└─────────────────────┘
            │
            ▼
        ( END )
```

# FIG. 8

```
INTERFACE
 IN1,IN2;OUT1,OUT2 ;;
NETLIST
 1,AND;IN1,IN2       ;S1      ;;
 2,AND;NT1,NT2       ;R1      ;;
 3,AND;NY1,IN1,NT2 ;S2      ;;
 4,AND;NT1,IN2       ;R2      ;;
 5,OR ;NT1,Y1,Y2    ;OUT1  ;;
 6,AND;Y1 ,IN2,NY2 ;OUT2  ;;
 7,INV;IN1             ;NT1    ;;
 8,INV;IN2             ;NT2    ;;
 9,FF ;S1 ,R1         ;Y1,NY1;;
 0,FF ;S2 ,R2         ;Y2,NY2;;
```

# FIG. 9

# FIG. 10

```
rule-1
 kind      : cell
 net       : -, [pm]        ;C           ;-        ;        ;
             -, [neg_out] ;=             ;C        ;        ;
 relation : unique(C)
rule-2(N)
 kind      : cell
 net       : -, [p]         ;-           ;C        ;        ;
             -, [neg_in]   ; (C)         ;=        ;=       ;
 relation : unique(C), rule-2(N)
rule-3(SYMBOL,* C)
 kind      : clock
 net       : -, SYMBOL      ;=           ;=        ;=       ;*C
 relation : rule-3(SYMBOL,* C)
rule-4([ff],C)
 kind      : ff
 net       : -, [ff]        ;=           ;=        ;=       ;C1
 relation : ck(C1,C), rule-4([ff],C)
rule-5([ff],N)
 kind      : ff
 net       : N, [ff]        ; (C)        ;=        ;=       ;=
           : M, [ff]        ;=           ;=(C)     ;=       ;=
 relation : rule-5([ff],M)
rule-6([bus])
 kind      : bus
 net       : -,-            ;+([bus])    ;+([bus]);+([bus]);+([bus])
 relation : rule-6([bus])
rule-7
 kind      : inv
 net       : -, [p]         ;[interface] ;-        ;        ;
 relation :
```

# FIG. 11

START

111 NET LIST NOT COLLATED WITH RULE ? —— NONE —→ RETURN

PRESENCE

112 RULE CORRESPONDING TO NET, NONE, PRESENCE ? —— NONE —→

PRESENCE

113 RELATION ? —— NOT ESTABLISHED —→

ESTABLISHED

114 CALL OF RULE ? —— NONE —→

PRESENCE

115 CLUSTER EXTRACTION BY CONNECTION SEARCH ? —— POSSIBLE —→ 117 CLUSTER EXTRACTION BY CONNECTION SEARCH —→ 118 ADDITION OF CLUSTER NAME TO NET LIST

IMPOSSIBLE

116 CLUSTER EXTRACTION

# FIG. 12

```
act-1 (X1, X2, Y1, Y2, X1, Y2)
  kind     : cell
  rule     : −
  connect  : −
  act      : X <-X1+0. 5
             move (-, [X2, YY], [X, YY])
act-2 (X1, X2, Y1, Y2, X, Y)
  kind     : ff
  rule     : rule-4
  connect  : y (NUM<4)
  act      : shift (interval, [-, 1])
             YY <-ymax (interval)
             move (main, [XX, -], [XX, YY])
act-3 (X1, #, Y1, Y2, #, Y)
  kind     : ff
  rule     : −
  connect  : n
  act      : XX <-xmax (main)
             shift (main, [XX, -])
act-4 (X1, X2, Y1, Y2, X, Y)
  kind     : ff
  rule     : −
  connect  : y
  act      : XX <-xmin (main)
             Y1 <-max (-)
             YY <-Y1+1
             move-block (main, [XA, -], [XX, YY])
             XA > XX
act-5 (X, X, Y, Y, X, #)
  kind     : inv
  rule     : rule-7
  connect  : −
  act      : move (main, [X, Y], [X, 0])
             direction (main, down)
```

## FIG. 13

## FIG. 14

## FIG. 15(a)

## FIG. 15(b)

# FIG. 16

① (IN2 , IN1)          (IN1)
    8    7              7

```
1 ─┐
2 ─┘─ 9 ─┐ 7
3 ─┐       ├─ 5 ─(OUT1)
4 ─┘─ 0 ─┘
1 ─┐
2 ─┘─ 9
1 ─┐
2 ─┘─ 9 ─┐
3 ─┐       ├─ 6 ─(OUT2)
4 ─┘─ 0 ─┘
1 ─┐
2 ─┘─ 9
```

② (IN2 , IN1)
    8    7

```
1 ─┐
2 ─┘─ 9 ──── 5 ─(OUT1)
3 ─┐
4 ─┘─ 0 ──── 6 ─(OUT2)
```

③ IN2 , IN1

FIG. 17

FIG. 18

# FIG. 19

151 → 152 BASIC ARRANGEMENT PROCESSING PART → 157 ARRANGEMENT MODIFICATION PROCESSING PART → 154 ARRANGEMENT MODIFICATION RULE AUTOMATIC GENERATOR PART → 156

153 ARRANGEMENT CHANGE DEVICE → 154

155 ARRANGEMENT MODIFICATION RULE PART

EP 0 384 571 A2

## FIG. 20

START

INPUT OF BLOCK INFORMATION — 161

BASIC ARRANGEMENT PROCESSING — 162

ARRANGEMENT MODIFICATION BY RULE — 168

DIAGRAM DISPLAY — 163

MODIFICATION PART IN DIAGRAM — 164  NONE

PRESENCE

END

DIAGRAM DISPLAY OF APPLICABLE PART — 165

MODIFICATION OF DIAGRAM — 166

PREPARATION AND REGISTRATION OF RULE — 167

# FIG. 21

| ITEM | PATTERN MATCHING | NET LIST SEARCH | PRESENT INVENTION |
|---|---|---|---|
| DISPLAY OF GROUPS OF CONTENTS | — | × | ○ |
| EXTRACTION OF GROUPS | LIMITATION IN SHAPES (1-1) | — | PARTIAL COLLATION (1-MANY) |
| ADDITION AND CHANGE OF MODIFICATION RULE | INCREASE OF THE NUMBER OF RULES | — | REALIZED BY COMBINATION OF A FEW RULES |

# FIG. 22

201    202

→    →

INPUT DEVICE ⌐203

↓

ARRANGING DEVICE ⌐204

↓

OUTPUT DEVICE ⌐205

↓    ↓    ↓
206    207    208

# FIG. 23

① a YEAR          b YEAR          c YEAR
CONTENTS A       CONTENTS B       CONTENTS C

c YEAR
CONTENTS C'

② a YEAR          b YEAR          c YEAR
CONTENTS A       CONTENTS B       CONTENTS C

c YEAR
CONTENTS C'

③ a YEAR          b YEAR          c YEAR
CONTENTS A       CONTENTS B       CONTENTS C

c YEAR
CONTENTS C'